# EUROPÄISCHE PATENTSCHRIFT

(11) **EP 2 603 973 B1**
(45) Veröffentlichungstag und Bekanntmachung des Hinweises auf die Patenterteilung: **18.07.2018**
(21) Anmeldenummer: 11749133.2
(22) Anmeldetag: 03.08.2011
(51) Int. Cl.: H03F 1/02, H03F 1/42, H03F 1/56, H03F 3/60

(54) **HOCHFREQUENZLEISTUNGSVERSTÄRKER MIT DOHERTY-ERWEITERUNG**
HIGH-FREQUENCY POWER AMPLIFIER HAVING DOHERTY ENHANCEMENT
AMPLIFICATEUR DE PUISSANCE HAUTES FRÉQUENCES ÉQUIPÉ D'UNE EXTENSION DOHERTY

(30) Priorität: 12.08.2010 DE 102010034067
(43) Veröffentlichungstag der Anmeldung: 19.06.2013
(73) Patentinhaber: Rohde & Schwarz GmbH & Co. KG, 81671 München (DE)
(72) Erfinder: SCHENK, Lothar, 12555 Berlin (DE)
(74) Vertreter: Körfer, Thomas
(86) Internationale Anmeldenummer: PCT/EP2011/063356
(87) Internationale Veröffentlichungsnummer: WO 2012/019949

(56) Entgegenhaltungen:
- EP-A1- 1 887 686
- WO-A1-2005/031967
- US-A1- 2007 008 032
- US-A1- 2010 176 885
- US-B1- 7 518 448
- US-B2- 7 688 135
- THOMAS LEHMANN ET AL: "Design and performance of sequential power amplifiers", MICROWAVE SYMPOSIUM DIGEST, 2008 IEEE MTT-S INTERNATIONAL, IEEE, PISCATAWAY, NJ, USA, 15. Juni 2008 (2008-06-15), Seiten 767-770, XP031326895, ISBN: 978-1-4244-1780-3

## Beschreibung

Die Erfindung betrifft einen Hochfrequenzleistungsverstärker, insbesondere einen als Doherty-Verstärker betreibbaren Hochleistungsverstärker.

Herkömmlich werden Hochfrequenzleistungsverstärker oftmals im AB-Betrieb betrieben, d.h. mittels z.B. vorgeschalteter Dioden wird eine Basisvorspannung erzeugt, welche die eingesetzten Transistoren schon bei kleinen Pegeln leitend machen. Im AB-Betrieb werden kleine Signale wie im A-Betrieb und große Signale wie im B-Betrieb verstärkt. Solche Verstärker arbeiten besonders verzerrungsarm, jedoch mit einem schlechten Wirkungsgrad.

Zur Verbesserung des Wirkungsgrads sind darüber hinaus Doherty-Verstärker bekannt. In der Mobilfunktechnik, insbesondere bei Modulationsverfahren mit nicht konstanter Einhüllenden und hohem Crest-Faktor (z.B. COFDM-Signale) haben in den letzten Jahren Hochfrequenzverstärker nach dem Doherty-Prinzip zunehmend Verbreitung gefunden. So zeigt z.B. das US-Patent US 7,688,135 B2 einen solchen Doherty-Verstärker. Nachteilhaft an solchen Verstärkern ist jedoch, dass diese lediglich eine sehr geringe Bandbreite aufweisen.

Das Dokument US 2010/0176885 A1 zeigt einen Doherty-Verstärker, welcher einen Hauptverstärkerpfad und mehrere Hilfsverstärkerpfade aufweist.

Das Dokument EP 1 887 686 A1 zeigt eine Verstärkerschaltung nach dem Doherty-Prinzip. Die Schaltung beinhaltet einen Hauptverstärkerpfad und mehrere Hilfsverstärkerpfade. Jeder Hilfsverstärkerpfad verfügt über ein Eingangsanpassnetzwerk und ein Ausgangsanpassnetzwerk, welche jeweils mittels Schalteinrichtungen in den Signalpfad geschaltet werden können und alternativ überbrückt werden können.

Der Erfindung liegt die Aufgabe zugrunde, einen Hochleistungsverstärker zu schaffen, mit welchem ein hoher Wirkungsgrad erreichbar ist und welcher in einem breiten Frequenzbereich einsetzbar ist.

Die Aufgabe wird erfindungsgemäß für die Vorrichtung durch die Merkmale des unabhängigen Anspruchs 1 gelöst. Vorteilhafte Weiterbildungen sind Gegenstand der hierauf rückbezogenen Unteransprüche.

Ein erfindungsgemäßer Hochfrequenzleistungsverstärker verfügt somit über einen Breitbandverstärker und eine Doherty-Erweiterung. Der Breitbandverstärker weist dabei einen Leistungsteiler, einen Hauptverstärkerpfad und einen Hilfsverstärkerpfad auf. Die Doherty-Erweiterung weist zumindest eine erste Offset-Leitung, eine zweite Offset-Leitung und einen Impedanzinverter auf. Der Breitbandverstärker verstärkt ein Eingangssignal und führt das verstärkte Signal der Doherty-Erweiterung oder einer weiteren Verarbeitungseinrichtung zu.

Der erfindungsgemäße Hochfrequenzleistungsverstärker ist insbesondere für den Einsatz in großen modularen Halbleiter-Rundfunksender-Endstufen für amplitudenmodulierte Signale (z.B. COFDM-Signale) geeignet. Er bietet die Möglichkeit, unter weitgehender Vermeidung der Nachteile des Stands der Technik das Verstärkerprinzip nach Doherty anzuwenden. Der Breitbandverstärker, welcher aus mehreren Verstärkermodulen bestehen kann, deckt breitbandig und abgleichfrei einen großen Frequenzbereich (z.B. UHF-Band IV-V 470-862 MHz) ab. Der Breitbandverstärker und die Doherty-Erweiterung bilden gemeinsam einen Doherty-Verstärker. Die Doherty-Erweiterung beinhaltet dabei die dem Doherty-Prinzip eigenen, die Bandbreite begrenzenden Bestandteile: einen (abstimmbaren) Impedanzinverter sowie ein oder zwei (abstimmbare) Offset-Leitungen und einen breitbandigen Impedanztransformator. Damit ist die Begrenzung der Bandbreite von dem Breitband-Verstärker getrennt. Bei Bedarf kann durch eine einfache mechanische Umstimmung der Impedanztransformations- und Offset-Leitungen in relativ kurzer Zeit eine neue Frequenz eingestellt werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: einen beispielhaften Hochfrequenzleistungsverstärker, und
- Fig. 2: ein Ausführungsbeispiel des erfindungsgemäßen Hochfrequenzleistungsverstärkers.

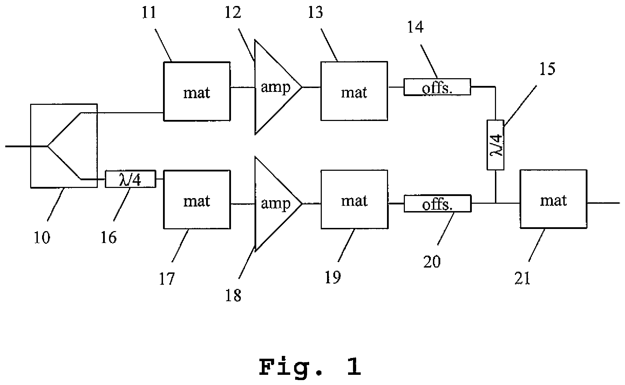

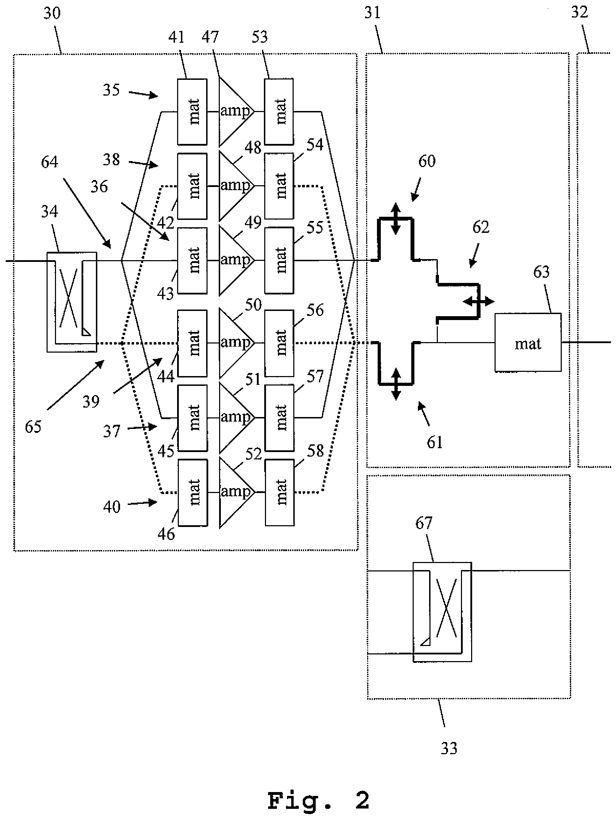

Zunächst werden anhand der Fig. 1 der Aufbau und die Funktionsweise eines herkömmlichen Doherty-Verstärkers und davon ausgehend die der gegenwärtigen Erfindung zugrundeliegende Problematik erläutert. Anschließend werden anhand von Fig. 2 der Aufbau und die Funktionsweise eines Ausführungsbeispiels der erfindungsgemäßen Vorrichtung gezeigt. Identische Elemente wurden in ähnlichen Abbildungen zum Teil nicht wiederholt dargestellt und beschrieben.

In Fig. 1 wird ein beispielhafter Doherty-Verstärker dargestellt. Ein Signaleingang ist mit einem Leistungsteiler 10 verbunden. Ein erster Ausgang des Leistungsteilers 10 ist mit einem Anpassnetzwerk 11 verbunden. Das Anpassnetzwerk 11 ist mit einem Haupttransistor 12 verbunden. Dieser ist mit einem weiteren Anpassnetzwerk 13 verbunden. Das Anpassnetzwerk 13 ist mit einer Offset-Leitung 14 verbunden. Diese ist mit einem Impedanzinverter 15 verbunden. Der zweite Eingang des Leistungsteilers 10 ist mit einem Phasenschieber 16 verbunden. Dieser ist mit einem dritten Anpassnetzwerk 17 verbunden. Der Leistungsteiler 10 verursacht dabei keine Phasendrehung. Das Eingangssignal wird zu gleichen Teilen auf seine beiden Ausgangspfade verteilt. Das Anpassnetzwerk 17 ist mit einem Hilfstransistor 18 verbunden. Dieser ist mit einem vierten Anpassnetzwerk 19 verbunden, welches mit einer zweiten Offset-Leitung 20 verbunden ist. Die Offset-Leitung 20 und der Impedanzinverter 15 sind mit einem fünften Anpassnetzwerk 21 verbunden. Das fünfte Anpassnetzwerk 21 passt die Impedanz des Doherty-Verstärkers an die von weiteren folgenden Systemkomponenten benötigte Impedanz an.

Der Haupttransistor 12, welcher im AB-Betrieb betrieben wird, arbeitet bei kleinen Eingangssignalen an einem erhöhten Lastwiderstand so, dass er bereits ab einem relativ kleinen Pegel, z.B. 6dB unter dem 1dB-Kompressionspunkt, in die Sättigung geht und somit mit maximalem Wirkungsgrad arbeitet. Oberhalb der durch den Sättigungspegel an dem Haupttransistor 12 festgelegten Pegelschwelle wirkt der Hilfstransistor 18 im C-Betrieb. Er verringert durch sein Ausgangssignal den Lastwiderstand des Haupttransistors 12. Bei Vollaussteuerung ist dadurch der Lastwiderstand des Haupttransistors um das Verhältnis zwischen Pegelschwelle und 1dB-Kompressionspunkt vermindert und der Haupttransistor 12 gibt die entsprechend höhere Leistung ab. Im -6dB-Beispiel führt ein halbierter Widerstand zu verdoppelter Leistung.

Ab der Pegelschwelle gibt der Haupttransistor 12 also trotz Sättigung eine steigende Ausgangsleistung ab und arbeitet dabei immer mit maximalem Wirkungsgrad. Dieser wird nur während der Betriebsphasen des Hilfstransistor 18 durch dessen Leistungsaufnahme verringert, bleibt aber verglichen mit einem konventionellen AB-Verstärker deutlich höher. Bei Vollaussteuerung des Hilfstransistors 18 in den Signalspitzen liefern beide Transistoren 12, 18 je die halbe Ausgangsleistung des Systems.

Die dynamische Verringerung des Lastwiderstands des Haupttransistors 12 erfolgt wie folgt: Beide Transistoren 12, 18 arbeiten an dem gleichen Lastwiderstand, im Fall der 6 dB-Schwelle, dem halben System-Wellenwiderstand, üblicherweise 25 Ohm, wobei der Hilfstransistor 18 direkt und der Haupttransistor 12 über einen Impedanzinverter 15 mit der Last verbunden sind. Bei kleinen Pegeln arbeitet der Hilfstransistor 18 nicht. Sein Ausgang ist hochohmig und stört deshalb nicht. Die Transistorkapazität ist durch ein Anpassnetzwerk 18 und eine Offset-Leitung 20 abgestimmt. Der Haupttransistor 12 arbeitet an der durch den Impedanzinverter 15 vergrößerten Last. D.h. der Impedanzinverter hat den Wellenwiderstand 50 Ohm, es ergibt sich somit unterhalb der Einsatzschwelle des Hilfstransistors 18 eine Last von 100 Ohm. Der dem Strom des Haupttransistors 12 am Lastwiderstand ab der Pegelschwelle überlagerte Ausgangsstrom des Hilfstransistors 18 verringert über den Impedanzinverter 15 den wirksamen Lastwiderstand des Haupttransistors 12. Gleichzeitig fällt die Lastimpedanz des Hilfstransistors 18 (ideal aus einem Leerlauf heraus) entsprechend ab, sodass er beginnt, einen Teil der Ausgangsleistung zu liefern.

Als Impedanzinverter 15 wird üblicherweise eine auf ein Viertel der Betriebswellenlänge dimensionierte Leitung verwendet. Die dadurch im Zweig des Haupttransistors 12 auftretende Verzögerung wird am Eingang des Hilfstransistors 18 kompensiert. Dies erfolgt in diesem Ausführungsbeispiel ebenfalls mittels einer als Phasenschieber genutzten λ/4-Leitung. Alternativ kann ein 90°-Leistungsteiler eingesetzt werden.

Damit die Ausgangsimpedanzen des Haupttransistors 12 und des Hilfstransistors 18 hinter dem Anpassungsnetzwerk 13 bzw. 19 reell und hochohmig sind, werden üblicherweise zwei Offset-Leitungen 14, 20 vorgesehen. Das Anpassungsnetzwerk 14 bzw. 19 kann so frei dimensioniert werden. Umgekehrt sorgt die Offset-Leitung 14 beim Haupttransistor 12 auch dafür, dass sich die dynamische Widerstandsänderung am Eingang des Impedanzinverters 15 vom Haupttransistor aus gesehen bei der Betriebsfrequenz reell an den Drain transformiert, im 6db-Beispiel von 100 Ohm auf 50 Ohm.

Hauptnachteil der Doherty-Verstärker ist, dass die als Phasenschieber 15 und Impedanzinverter 16 benötigten λ/4-Leitungen sowie die Offset-Leitungen 14, 20 nur bei einer Frequenz exakt arbeiten. Dadurch ist die Bandbreite auf maximal +/- 10 % der dimensionierten Frequenz beschränkt. Die für die Abdeckung größerer Bandbreiten notwendige Variantenbildung ließ den Einsatz des Doherty-Prinzips insbesondere in den TV-Rundfunkbereichen bisher als nicht sinnvoll erscheinen.

In Fig. 2 wird ein Ausführungsbeispiel des erfindungsgemäßen Verstärkers dargestellt. Der Hochfrequenzleistungsverstärker besteht aus einem Breitbandverstärker 30, einer Doherty-Erweiterung 31 und optional einer Koppeleinrichtung 33. Der Breitbandverstärker 30 beinhaltet dabei einen 90°-Koppler 34, welcher ein Eingangssignal zu je 50% auf zwei Koppelpfade aufteilt. Alternativ kann wie in Fig. 1 gezeigt ein 0°-Leistungsteiler und ein Phasenschieber eingesetzt werden. Dies beschränkt jedoch signifikant die Bandbreite.

Ein erster Koppelpfad des Kopplers 34 ist mit einem Hauptverstärkerpfad 64 verbunden. Der zweite Koppelpfad des Kopplers 34 ist mit einem Hilfsverstärkerpfad 65 verbunden. Der Hauptverstärkerpfad 64 und der Hilfsverstärkerpfad 65 werden dabei jeweils von hier nicht dargestellten Leistungsteilern mit 0°-Phasenverschiebung auf mehrere Verstärkerpfade 35, 36, 37, 38, 39, 40 aufgeteilt.

In diesem Ausführungsbeispiel beinhaltet der Hauptverstärkerpfad 64 drei Verstärkerpfade 35, 36 und 37, während der Hilfsverstärkerpfad 65 ebenfalls drei Verstärkerpfade 38, 39 und 40 beinhaltet. Jeder Verstärkerpfad 35 - 40 beinhaltet dabei ein Anpassnetzwerk 41 - 46, einen Verstärkertransistor 47 - 52 und ein zweites Anpassnetzwerk 53 - 58. Jeder einzelne Verstärkerpfad 35, 36, 37 des Hauptverstärkerpfads 64 erfüllt dabei die Funktion der Anpassnetzwerke 11, 13 und des Haupttransistors 12 aus Fig. 1. Jeder Verstärkerpfad 38, 39, 40 des Hilfsverstärkerpfads 65 erfüllt dabei die Funktion der Anpassnetzwerke 17, 19 und des Hilfstransistors 18 aus Fig. 1. Durch hier ebenfalls nicht dargestellte Leistungskombinierer werden die Ausgangssignale der Verstärkerpfade 35 - 40 getrennt nach Hauptverstärkerpfad 64 und Hilfsverstärkerpfad 65 erneut zusammengeführt. D.h. die Ausgangssignale der Verstärkerpfade 35, 36, 37 werden zusammengeführt, während die Ausgangssignale der Verstärkerpfade 38, 39, 40 zusammengeführt werden.

Abweichend zu dem hier dargestellten Ausführungsbeispiel können auch unterschiedliche Anzahlen von Verstärkerpfaden eingesetzt werden. So ist selbst ein Einsatz jeweils nur eines Verstärkerpfads im Hauptverstärkerpfad 64 und im Hilfsverstärkerpfad 65 möglich. Auch ein Einsatz abweichender Verstärkerpfadanzahlen im Hauptverstärkerpfad 64 und im Hilfsverstärkerpfad 65 ist möglich. So könnte z.B. für Signale, welche lediglich einen geringen Amplitudenunterschied zwischen minimaler und maximaler Amplitude aufweisen, eine größere Anzahl von Verstärkerpfaden im Hauptverstärkerpfad 64 vorgesehen sein. Andererseits könnte für Signale, welche einen sehr großen Unterschied zwischen der minimalen und maximalen Amplitude aufweisen eine größere Anzahl von Verstärkerpfaden im Hilfsverstärkerpfad 65 vorgesehen sein.

Die zusammengefassten Signale des Hauptverstärkerpfads 64 und des Hilfsverstärkerpfads 65 werden anschließend der Doherty-Erweiterung 31 zugeführt. Dabei wird das Signal des Hauptverstärkerpfads 64 einer ersten Offset-Leitung 60 zugeführt, während die Signale des Hilfsverstärkerpfads 65 einer zweiten Offset-Leitung 61 zugeführt werden. Wie schon anhand von Fig. 1 beschrieben, bewirken die Offset-Leitungen 60, 61, dass die Impedanzen der Verstärkerpfade 35 - 40 hinter den Anpassnetzwerken 53 - 58 bei der Betriebsfrequenz reell und hochohmig sind. Bei der Betriebsfrequenz ist somit eine reelle Abbildung der Lastwiderstandsverhältnisse auf die Transistoren des Hauptverstärkerpfads 64 und des Hilfsverstärkerpfads 65 realisiert.

Der Ausgang der ersten Offset-Leitung 60, welche mit dem Hauptverstärkerpfad 64 verbunden ist, ist mit einem Impedanzinverter 62 verbunden. Dieser erfüllt dieselbe Funktion wie der Impedanzinverter 15 aus Fig. 1. Die Ausgänge des Impedanzinverters 62 und der zweiten Offset-Leitung 61 sind mit einem Ausgangsanpassnetzwerk 63 verbunden. Dieses transformiert die Impedanz auf eine von weiteren angeschlossenen Verarbeitungseinrichtungen benötigte Impedanz.

Der Breitbandverstärker 30 und die Doherty-Erweiterung 31 sind dabei optional als je ein Modul aufgebaut. So kann der Breitbandverstärker 30 ohne Abstimmung der Offset-Leitungen 60, 61 und des Impedanzinverters 62 breitbandig vermessen werden.

Optional beinhaltet der Hochfrequenzleistungsverstärker weiterhin eine Koppeleinrichtung 33. Die Koppeleinrichtung 33 beinhaltet einen 90°-Koppler 67. Die Koppeleinrichtung 33 kann dabei von einer hier nicht dargestellten Schalteinrichtung statt der Doherty-Erweiterung 31 direkt mit dem Breitbandverstärker 30 verbunden werden. Der 90°-Koppler 67 koppelt dann die beiden Ausgangssignale des Breitbandverstärkers 30 auf eine gemeinsame Leitung und führt das Ausgangssignal dem Ausgangsanpassnetzwerk 68 zu. Werden die Hilfstransistoren 48, 50, 52 ebenfalls im AB-Betrieb betrieben, so ergibt sich in dieser Schaltung ein vollständig im AB-Betrieb arbeitender Hochfrequenzleistungsverstärker. Diese Option ist insbesondere dann sinnvoll, wenn eine Anpassung der Offset-Leitungen 60, 61 und des Impedanzinverters 62 z.B. aus zeitlichen Gründen nicht möglich ist. Eine geringere Effizienz des Hochfrequenzleistungsverstärkers muss in diesem Fall jedoch in Kauf genommen werden.

Die Endstufe ist somit in zwei Gruppen zu je n Transistoren aufgeteilt. Bei Einsatz der Doherty-Erweiterung 31 bildet eine Gruppe den Hauptverstärker, während die andere Gruppe den Hilfsverstärker bildet. Wird die Koppeleinrichtung 33 eingesetzt, können beide Gruppen gleichberechtigt eine herkömmliche Endstufe bilden.

Jeder Transistor der beiden Transistorgruppen wird über 0°-Leistungsteiler angesteuert und ihre Leistung über 0°-Leistungskombinierer summiert den getrennten Ausgängen zugeführt. Diese Maßnahme stellt sicher, dass alle Endstufentransistoren einer Gruppe nach Betrag und Phase den gleichen Lastwiderstand sehen.

Die Arbeitspunkte der Endstufengruppen können getrennt voneinander von einer hier nicht dargestellten Steuereinrichtung gesteuert werden. Dadurch wird der AB-Betrieb für die Verstärkertransistoren 47, 49, 51 des Hauptverstärkerpfads 64 eingestellt und der C-Betrieb führt die Verstärkertransistoren 48, 50, 52 des Hilfsverstärkerpfads 65 eingestellt. Wird optional die Koppeleinrichtung 33 statt der Doherty-Erweiterung 31 eingesetzt, so wird bei sämtlichen Verstärkertransistoren 47 - 52 der AB-Betrieb eingestellt.

Wird die Doherty-Erweiterung 31 eingesetzt, sorgt der 90°-Koppler 34 für den notwendigen Phasenversatz, der von dem Impedanzinverter 62 erzeugt wird. Das Anpassnetzwerk 63 erzeugt die für das Dohertysystem nötige Systemlast von 25 Ohm. Weiterhin stellt es weiteren Komponenten 32 eine breitbandige Last von 50Ohm zur Verfügung. Optional kann ein konventioneller Hochleistungsleistungskombinierer bei Bedarf mehrere Verstärkermodule mit Doherty-Erweiterungen zu noch größeren Verstärkereinheiten zusammenfassen.

Zur Verringerung der Anzahl von Abstimmelementen kann die Offset-Leitung 60 mit dem Impedanzinverter 62 zu einem gemeinsamen Abstimmelement zusammengelegt werden. Es sind so lediglich zwei Abstimmelemente innerhalb der Doherty-Erweiterung 31 an die einzusetzende Frequenz anzupassen. Es ist auch möglich, die Gruppenausgänge mehrerer Verstärkermodule jeweils nochmals über getrennte 0°-Leistungskombinierer zusammenzufassen und z.B. 4 Breitbandverstärker mit einer Doherty-Erweiterung zu betreiben. Der Nachteil ist, dass das System mit wachsender Laufzeit zwischen Doherty-Erweiterung und Verstärkertransistor immer schmalbandiger wird.

Das Ausgangsanpassnetzwerk 63 bzw. 68 kann optional eine Blitzschutzfunktion enthalten. Durch die optionale modulare Bauweise der Doherty-Erweiterung 31 und der Koppeleinrichtung 33 wird erreicht, dass sowohl der Breitbandverstärker 30 als auch weitere Komponenten 32, z.B. eine Antenne und/oder ein Filter jeweils breitbandig vermessen werden können, ohne Komponenten auf den eingesetzten Frequenzbereich abstimmen zu müssen.

Optional kann die Doherty-Erweiterung 31 mit fest dimensionierten Offset-Leitungen 60, 61 und einem fest dimensionierten Impedanzinverter 62 ausgestattet sein. In diesem Fall ist die Doherty-Erweiterung auf einen festen Frequenzbereich eingeschränkt. Insbesondere für häufig genutzte Frequenzbereiche ist eine solche Doherty-Erweiterung jedoch sinnvoll.

Bei dem Aufbau des Breitbandverstärkers 30 sind weiterhin thermische Gesichtspunkte zu berücksichtigen. Nachdem die Verstärkertransistoren 47, 49, 51 des Hauptverstärkerpfads 64 stets in Betrieb sind und einen großen Teil der Systemlast tragen, erzeugen sie auch den überwiegenden Teil der Systemabwärme. Es ist somit empfehlenswert, die Verstärkertransistoren 47, 49, 51 des Hauptverstärkerpfads 64 abwechselnd mit den Transistoren 48, 50, 52 des Hilfsverstärkerpfads auf einen gemeinsamen Kühlkörper anzuordnen. Die thermische Last des Systems wird so sehr gleichmäßig über den Kühlkörper verteilt.

Soll der Hochfrequenzleistungsverstärker lediglich mit der Doherty-Erweiterung 31 betrieben werden, sollte der in Fig. 2 nicht dargestellte Leistungskombinierer des Hauptverstärkerpfads 64, welcher praktisch die gesamte mittlere Ausgangsleistung abführt, in Streifenleitertechnik so ausgeführt werden, dass ein Blechmäander mit Luft als Dielektrikum in entsprechenden Ausfräsungen des Kühlkörpers oder der Montageplatte geführt wird. Der Leistungskombinierer des Hilfsverstärkerpfads 65, welche in Fig. 2 ebenfalls nicht dargestellt wird, erzeugt lediglich eine sehr geringe thermische Leistung und kann somit problemlos auf der Leiterplatte untergebracht werden, die den Leistungskombinierer des Hauptverstärkerpfads 64 gleichsam abdeckt.

Muss der Hochfrequenzleistungsverstärker auch klassisch, d.h. mit der Koppeleinrichtung 33 betrieben werden können, sollten beide Leistungskombinierer in Streifenleitertechnik so ausgeführt werden, dass ein Blechmäander mit Luft als Dielektrikum in entsprechenden Ausfräsungen des Kühlkörpers oder der Montageplatte geführt wird. Hier muss der Leistungskombinierer des Hauptverstärkerpfads 64 ebenfalls für doppelte Leistung, der des Hilfsverstärkerpfads 65 für die normale Leistung, in klassischer Betriebsart ausgelegt sein.

Der 90°-Koppler 34 ist vorteilhafterweise aus drei λ/4-langen Kopplerstrukturen aufgebaut. Ein schaltbares Dämpfungsglied vor dem Hauptverstärker kann für die Betriebsart mit der Doherty-Erweiterung 31 eine evtl. notwendige unsymmetrische Leistungsteilung sicherstellen. Bei reinem Doherty-Betrieb kann natürlich der Koppler selbst unsymmetrisch ausgeführt sein.

Die Erfindung ist nicht auf das dargestellte Ausführungsbeispiel beschränkt. Alle vorstehend genannten Merkmale oder in den Figuren gezeigten Merkmale sind im Rahmen der Erfindung beliebig vorteilhaft miteinander kombinierbar.

## Patentansprüche

1. Hochfrequenzleistungsverstärker mit einem Breitbandverstärker (30), einer Doherty-Erweiterung (31) und einer Koppeleinrichtung (33),
wobei der Breitbandverstärker (30) einen Leistungsteiler (34), einen Hauptverstärkerpfad (64) und einen Hilfsverstärkerpfad (65) aufweist, und
wobei die Doherty-Erweiterung (31) zumindest eine erste Offset-Leitung (60), eine zweite Offset-Leitung (61) und einen Impedanzinverter (62) aufweist,
**dadurch gekennzeichnet,**
**dass** die Koppeleinrichtung (33) einen 90°-Koppler beinhaltet, welcher ausgebildet ist, um den Hauptverstärkerpfad (64) und den Hilfsverstärkerpfad (65) auf eine gemeinsame Leitung zu koppeln,
**dass** der Breitbandverstärker (30) mittels einer Schalteinrichtung mit der Doherty-Erweiterung (31) verbunden ist,
**dass** der Breitbandverstärker (30) mittels der Schalteinrichtung weiterhin mit der Koppeleinrichtung (33) verbunden ist, und
**dass** die Schalteinrichtung den Breitbandverstärker (30) zwischen der Doherty-Erweiterung (31) und der Koppeleinrichtung (33) umschaltet.

2. Hochfrequenzleistungsverstärker nach Anspruch 1,
**dadurch gekennzeichnet,**
**dass** der Hauptverstärkerpfad (64) zumindest einen Verstärkerpfad (35, 36, 37) beinhaltet, und
**dass** der Hilfsverstärkerpfad zumindest einen Verstärkerpfad (38, 39, 40) beinhaltet.

3. Hochfrequenzleistungsverstärker nach Anspruch 2,
**dadurch gekennzeichnet,**
**dass** der Hauptverstärkerpfad (64) weiterhin einen Leistungsteiler, einen Leistungskombinierer und zumindest zwei Verstärkerpfade (35, 36, 37) beinhaltet,
**dass** der Leistungsteiler eine Leistung des Hauptverstärkerpfads (64) auf die Verstärkerpfade (35, 36, 37) aufteilt, und
**dass** der Leistungskombinierer Leistungen der Verstärkerpfade (35, 36, 37) zusammenführt.

4. Hochfrequenzleistungsverstärker nach Anspruch 2 oder 3,
**dadurch gekennzeichnet,**
**dass** der Hilfsverstärkerpfad (65) weiterhin einen Leistungsteiler, einen Leistungskombinierer und zumindest zwei Verstärkerpfade (38, 39, 40) beinhaltet,
**dass** der Leistungsteiler eine Leistung des Hilfsverstärkerpfads (65) auf die Verstärkerpfade (38, 39, 40) aufteilt, und
**dass** der Leistungskombinierer Leistungen der Verstärkerpfade (38, 39, 40) zusammenführt.

5. Hochfrequenzleistungsverstärker nach einem der Ansprüche 2 bis 4,
**dadurch gekennzeichnet,**
**dass** die Verstärkerpfade jeweils zumindest ein erstes Anpassnetzwerk (41, 42, 43, 44, 45, 46), einen Verstärkertransistor (47, 48, 49, 50, 51, 52) und ein zweites Anpassnetzwerk (53, 54, 55, 56, 57, 58) beinhalten, und
**dass** das erste Anpassnetzwerk (41, 42, 43, 44, 45, 46), der Verstärkertransistor (47, 48, 49, 50, 51, 52) und das zweites Anpassnetzwerk (53, 54, 55, 56, 57, 58) jeweils in Serie geschalten sind.

6. Hochfrequenzleistungsverstärker nach Anspruch 5,
**dadurch gekennzeichnet,**
**dass** Arbeitspunkte der Verstärkertransistoren (47, 49, 51) der Verstärkerpfade (35, 36, 37) des Hauptverstärkerpfads (64) und Arbeitspunkte der Verstärkertransistoren (49, 50, 52) der Verstärkerpfade (38, 39, 40) des Hilfsverstärkerpfads (65) getrennt von einer Steuereinrichtung einstellbar sind.

7. Hochfrequenzleistungsverstärker nach Anspruch 6,
**dadurch gekennzeichnet,**
**dass** durch die Steuereinrichtung einen Arbeitspunkt der Verstärkertransistoren (47, 49, 51) der Verstärkerpfade (35, 36, 37) des Hauptverstärkerpfads (64) derart einstellbar ist, dass diese im AB-Betrieb arbeiten, und dass durch die Steuereinrichtung einen Arbeitspunkt der Verstärkertransistoren (49, 50, 52) der Verstärkerpfade (38, 39, 40) des Hilfsverstärkerpfads (65) derart einstellbar ist, dass diese im C-Betrieb arbeiten, wenn der Breitbandverstärker (30) das verstärkte Signal der Doherty-Erweiterung (31) zuführt.

8. Hochfrequenzleistungsverstärker nach Anspruch 6 oder 7,
**dadurch gekennzeichnet,**
**dass** durch die Steuereinrichtung einen Arbeitspunkt der Verstärkertransistoren (47, 48, 49, 50, 51, 52) der Verstärkerpfade (35, 36, 37, 38, 39, 40) derart einstellbar ist, dass diese im AB-Betrieb arbeiten, wenn der Breitbandverstärker (30) das verstärkte Signal der Koppeleinrichtung (33) zuführt.

9. Hochfrequenzleistungsverstärker nach einem der Ansprüche 1 bis 8,
**dadurch gekennzeichnet,**
**dass** die Offset-Leitungen (60, 61) einstellbare Längen haben,
**dass** die Offset-Leitungen (60, 61) eine Betriebsfrequenz des Hochfrequenzleistungsverstärkers einstellen, und
**dass** die Offset-Leitungen (60, 61) bewirken, dass Impedanzen der Verstärkerpfade (35 - 40) hinter den Anpassnetzwerken (53 - 58) bei der Betriebsfrequenz reell und hochohmig sind.

10. Hochfrequenzleistungsverstärker nach einem der Ansprüche 1 bis 9,
**dadurch gekennzeichnet,**
**dass** der Impedanzinverter (62) eine einstellbare Betriebsfrequenz aufweist, und
**dass** der Impedanzinverter (62) in Abhängigkeit einer Amplitude eines zu verstärkenden Signals eine Impedanz des Hauptverstärkerpfads (64) anpasst.

## Claims

1. A high-frequency power amplifier with a broadband amplifier (30), a Doherty extension (31) and a coupling device (33),
wherein the broadband amplifier (30) comprises a power splitter (34), a main amplifier path (64) and an auxiliary amplifier path (65), and
wherein the Doherty extension (31) comprises at least one first offset line (60), a second offset line (61) and an impedance inverter (62),
**characterised in that**
the coupling device (33) contains a 90° coupler, which is embodied to couple the main amplifier path (64) and the auxiliary amplifier path (65) on a common line,
that the broadband amplifier (30) is connected by means of a switching device to the Doherty extension (31),
that the broadband amplifier (30) is further connected by means of the switching device to the coupling device (33), and
that the switching device switches the broadband amplifier (30) between the Doherty extension (31) and the coupling device (33).

2. The high-frequency power amplifier according to claim 1,
**characterised in that**
the main amplifier path (64) contains at least one amplifier path (35, 36, 37), and that the auxiliary amplifier path contains at least one amplifier path (38, 39, 40) .

3. The high-frequency power amplifier according to claim 2,
**characterised in that**
the main amplifier path (64) further contains a power splitter, a power combiner and at least two amplifier paths (35, 36, 37),
that the power splitter splits a power of the main amplifier path (64) between the amplifier paths (35, 36, 37), and
that the power combiner combines powers of the amplifier paths (35, 36, 37).

4. The high-frequency power amplifier according to claim 2 or 3,
**characterised in that**
the auxiliary amplifier path (65) further contains a power splitter, a power combiner and at least two amplifier paths (38, 39, 40),
that the power splitter splits a power of the auxiliary amplifier path (65) between the amplifier paths (38, 39, 40), and
that the power combiner combines powers of the amplifier paths (38, 39, 40).

5. The high-frequency power amplifier according to any one of claims 2 to 4,
**characterised in that**
the amplifier paths each contain at least one first matching network (41, 42, 43, 44, 45, 46), an amplifier transistor (47, 48, 49, 50, 51, 52) and a second matching network (53, 54, 55, 56, 57, 58), and
that the first matching network (41, 42, 43, 44, 45, 46), the amplifier transistor (47, 48, 49, 50, 51, 52) and the second matching network (53, 54, 55, 56, 57, 58) are each connected in series.

6. The high-frequency power amplifier according to claim 5,
**characterised in that**
the operating points of the amplifier transistors (47, 49, 51) of the amplifier paths (35, 36, 37) of the main amplifier path (64) and operating points of the amplifier transistors (49, 50, 52) of the amplifier paths (38, 39, 40) of the auxiliary amplifier path (65) are adjustable separately by a control device.

7. The high-frequency power amplifier according to claim 6,
**characterised in that**,
through the control device, an operating point of the amplifier transistors (47, 49, 51) of the amplifier paths (35, 36, 37) of the main amplifier path (64) is adjustable in such a manner that the latter operate in AB mode, and that, through the control device, an operating point of the amplifier transistors (49, 50, 52) of the amplifier paths (38, 39, 40) of the auxiliary amplifier path (65) is adjustable in such a manner that the latter operate in C mode, when the broadband amplifier (30) supplies the amplified signal to the Doherty extension (31).

8. The high-frequency power amplifier according to claim 6 or 7,
**characterised in that**,
through the control device, an operating point of the amplifier transistors (47, 48, 49, 50, 51, 52) of the amplifier paths (35, 36, 37, 38, 39, 40) is adjustable in such a manner that the latter operate in AB mode, when the broadband amplifier (30) supplies the amplified signal to the coupling device (33).

9. The high-frequency power amplifier according to any one of claims 1 to 8,
**characterised in that**
the offset lines (60, 61) have adjustable lengths,
that the offset lines (60, 61) adjust an operating frequency of the high-frequency power amplifier, and
that the offset lines (60, 61) cause impedances of the amplifier paths (35 - 40) behind the matching networks (53 - 58) to be real and high ohmic at the operating frequency.

10. The high-frequency power amplifier according to any one of claims 1 to 9,
**characterised in that**
the impedance inverter (62) comprises an adjustable operating frequency, and
that the impedance inverter (62) is matchable an impedance of the main amplifier path (64) dependent upon an amplitude of a signal to be amplified.

## Revendications

1. Amplificateur de puissance hautes fréquences comprenant un amplificateur large bande (30), une extension Doherty (31) et un système de couplage (33),
dans lequel l'amplificateur large bande (30) comprend un diviseur de puissance (34), un chemin d'amplification principal (64) et un chemin d'amplification auxiliaire (65), et
dans lequel l'extension Doherty (31) comprend au moins une première ligne de décalage (60), une deuxième ligne de décalage (61) et un inverseur d'impédance (62),
**caractérisé**
**en ce que** le système de couplage (33) comporte un coupleur 90°, lequel est conçu pour coupler le chemin d'amplificateur principal (64) et le chemin d'amplificateur auxiliaire (65) sur une ligne commune,
**en ce que** l'amplificateur large bande (30) est relié à l'extension Doherty (31) au moyen d'un système de commutation,
**en ce que** l'amplificateur large bande (30) est relié en outre au système de couplage (33) au moyen du système de commutation, et
**en ce que** le système de commutation fait basculer l'amplificateur large bande (30) entre l'extension Doherty (31) et le système de couplage (33).

2. Amplificateur de puissance hautes fréquences selon la revendication 1,
**caractérisé**
**en ce que** le chemin d'amplificateur principal (64) comporte au moins un chemin d'amplificateur (35, 36, 37), et
**en ce que** le chemin d'amplificateur auxiliaire comporte au moins un chemin d'amplificateur (38, 39, 40).

3. Amplificateur de puissance hautes fréquences selon la revendication 2,
**caractérisé**
**en ce que** le chemin d'amplificateur principal (64) comporte en outre un diviseur de puissance, un groupeur de puissance et au moins deux chemins d'amplificateur (35, 36, 37),
**en ce que** le diviseur de puissance divise une puissance du chemin d'amplificateur principal (64) sur les chemins d'amplificateur (35, 36, 37), et
**en ce que** le groupeur de puissance réunit les puissances des chemins d'amplificateur (35, 36, 37).

4. Amplificateur de puissance hautes fréquences selon la revendication 2 ou 3,
**caractérisé**
**en ce que** le chemin d'amplificateur auxiliaire (65) comporte en outre un diviseur de puissance, un groupeur de puissance et au moins deux chemins d'amplificateur (38, 39, 40),
**en ce que** le diviseur de puissance divise une puissance du chemin d'amplificateur auxiliaire (65) sur les chemins d'amplificateur (38, 39, 40), et
**en ce que** le groupeur de puissance réunit les puissances des chemins d'amplificateur (38, 39, 40).

5. Amplificateur de puissance hautes fréquences selon l'une quelconque des revendications 2 à 4,
**caractérisé**
**en ce que** les chemins d'amplificateur comportent chacun au moins un premier réseau d'adaptation (41, 42, 43, 44, 45, 46), un transistor amplificateur (47, 48, 49, 50, 51, 52) et un deuxième réseau d'adaptation (53, 54, 55, 56, 57, 58), et
**en ce que** le premier réseau d'adaptation (41, 42, 43, 44, 45, 46), le transistor d'amplificateur (47, 48, 49, 50, 51, 52) et le deuxième réseau d'adaptation (53, 54, 55, 56, 57, 58) sont montés chacun en série.

6. Amplificateur de puissance hautes fréquences selon la revendication 5,
**caractérisé**
**en ce que** les points de fonctionnement des transistors d'amplificateur (47, 49, 51) des chemins d'amplificateur (35, 36, 37) du chemin d'amplificateur principal (64) et les points de fonctionnement des transistors d'amplificateur (49, 50, 52) des chemins d'amplificateur (38, 39, 40) du chemin d'amplificateur auxiliaire (65) peuvent être réglés séparément d'un système de commande.

7. Amplificateur de puissance hautes fréquences selon la revendication 6,
**caractérisé**
**en ce que** le système de commande permet de régler un point de fonctionnement des transistors d'amplificateur (47, 49, 51) des chemins d'amplificateur (35, 36, 37) du chemin d'amplificateur principal (64) de telle manière que ceux-ci fonctionnent en mode AB, et
**en ce que** le système de commande permet de régler un point de fonctionnement des transistors d'amplificateur (49, 50, 52) des chemins d'amplificateur (38, 39, 40) du chemin d'amplificateur auxiliaire (65) de telle manière que ceux-ci fonctionnent en mode C, lorsque l'amplificateur large bande (30) amène le signal amplifié à l'extension Doherty (31).

8. Amplificateur de puissance hautes fréquences selon la revendication 6 ou 7,
**caractérisé**
**en ce que** le système de commande permet de régler un point de fonctionnement des transistors d'amplificateur (47, 48, 49, 50, 51, 52) des chemins d'amplificateur (35, 36, 37, 38, 39, 40) de telle manière que ceux-ci fonctionnent en mode AB, lorsque l'amplificateur large bande (30) amène le signal amplifié au système de couplage (33).

9. Amplificateur de puissance hautes fréquences selon l'une quelconque des revendications 1 à 8,
**caractérisé**
**en ce que** les lignes de décalage (60, 61) présentent des longueurs réglables,
**en ce que** les lignes de décalage (60, 61) règlent une fréquence de fonctionnement de l'amplificateur de puissance hautes fréquences, et
**en ce que** les lignes de décalage (60, 61) ont pour effet que les impédances des chemins d'amplificateur (35-40) derrière les réseaux d'adaptation (53-58) pour la fréquence de fonctionnement sont réelles et à impédance élevée.

10. Amplificateur de puissance hautes fréquences selon l'une quelconque des revendications 1 à 9,
**caractérisé**
**en ce que** l'inverseur d'impédance (62) présente une fréquence de fonctionnement réglable, et
**en ce que** l'inverseur d'impédance (62) adapte une impédance du chemin d'amplificateur principal (64) en fonction d'une amplitude d'un signal à amplifier.
